# EUROPEAN PATENT APPLICATION

(11) **EP 3 720 250 A1**
(43) Date of publication of application: **07.10.2020**
(21) Application number: 18883123.4
(22) Date of filing: 29.11.2018
(51) Int. Cl.: H05B 33/10, B26D 3/08, H01L 51/50, H05B 33/02, H05B 33/04

(54) **ELECTRONIC DEVICE MANUFACTURING METHOD**

(30) Priority: 01.12.2017 JP 2017231790
(71) Applicant: Sumitomo Chemical Company Limited, Tokyo 104-8260 (JP)
(72) Inventor: MORISHIMA Shinichi, Tsukuba-shi Ibaraki 300-3294 (JP); SHIMOGAWARA Masaya, Niihama-shi Ehime 792-0015 (JP); FUJII Takashi, Niihama-shi Ehime 792-0015 (JP)
(74) Representative: J A Kemp LLP
(86) International application number: PCT/JP2018/044031
(87) International publication number: WO 2019/107505

(57) **Abstract**

A manufacturing method for an electronic device 1 includes: a bonding step S09 of bonding a band-shaped sealing member 11, extending in one direction, along the one direction such that a portion of each of a first electrode layer 5 and a second electrode layer 9 in each electronic device part 10 is exposed and that the sealing member straddles a plurality of electronic device parts 10; a cutting step S05 of making a cut in a sealing body 20 that is a parent material of the sealing member 11 and has a larger dimension in the width direction, orthogonal to the one direction, than the sealing member 11 so as to form a width being the width of the sealing member 11, before the bonding step S09; and a separation step S08 of separating the sealing member 11 from the sealing body 20 in which the cut has been made, after the cutting step S05 and before the bonding step S09. In the bonding step S09, the sealing member 11, separated from the sealing body 20 in the separation step S08, is bonded.

## Description

### TECHNICAL FIELD

The present invention relates to a method for manufacturing an electronic device.

### BACKGROUND ART

As a conventional method for manufacturing an electronic device, for example, a method described in Patent Document 1 is known. In the method for manufacturing an electronic device described in Patent Document 1, a device having a structure in which at least a first base material, a first electrode, an electroluminescent layer, a second electrode, and a second base material are laminated in this order, is manufactured as two members separated at an intermediate portion of the structure, and the two members are bonded to form an electronic device. In this method for manufacturing an electronic device, a half-cut has been made on the electrode-side of at least one base material, and after the bonding of both members, an unnecessary portion is removed using a groove formed by the half-cut to expose at least one electrode.

### PRIOR ART DOCUMENT

### PATENT DOCUMENT

Patent Document 1: JP-A-2008-269964

### SUMMARY OF THE INVENTION

### PROBLEMS TO BE SOLVED BY THE INVENTION

In the conventional method for manufacturing an electronic device, the unnecessary portion is removed after the first base material and the second base material are bonded together. As described above, according to the conventional method, the operation is complicated since the two base materials are bonded together, and then the unnecessary portion is removed by bending the base materials with the groove formed by the half-cut, as a starting point.

An object of one aspect of the present invention is to provide a method for manufacturing an electronic device that can simplify manufacturing.

### MEANS FOR SOLVING THE PROBLEMS

A method for manufacturing an electronic device according to one aspect of the present invention includes: a formation step of forming a plurality of electronic device parts, obtained by laminating at least a first electrode layer, a functional layer, and a second electrode layer in this order, on one main surface of a support substrate extending in one direction at predetermined intervals in the one direction; a bonding step of bonding a band-shaped sealing member, extending in the one direction, along the one direction such that a portion of each of the first electrode layer and the second electrode layer in each of the electronic device parts is exposed and that the sealing member straddles the plurality of electronic device parts; a cutting step of making a cut in a sealing body that is a parent material of the sealing member and has a larger dimension in a width direction, orthogonal to the one direction, than the sealing member so as to form a width being a width of the sealing member, before the bonding step; and a separation step of separating the sealing member from the sealing body with the cut made. In the bonding step, the sealing member, separated from the sealing body in the separation step, is bonded.

In the method for manufacturing an electronic device according to one aspect of the present invention, a cut is made in the sealing body in the cutting step, and before the sealing member is bonded to the electronic device part in the bonding step, sealing member is separated from the sealing body. Then, the sealing member separated from the sealing body is bonded. Hence in the method for manufacturing an electronic device, it is not necessary to remove the unnecessary portion after the bonding of the sealing member. Therefore, in the method for manufacturing an electronic device, the manufacturing can be simplified.

In one embodiment, the sealing body may be provided with a peeling film, and the method may include a peeling step of peeling off the peeling film from the sealing body after the cutting step and before the bonding step. The peeling film is stuck to the sealing body until the sealing member is bonded. Therefore, adhesion of dust or the like to the sealing member can be prevented. As a result, it is possible to prevent the occurrence of a defect in the electronic device due to dust or the like.

In one embodiment, in the cutting step, a cut may be made so that the peeling film is not divided in the thickness direction of the peeling film from one surface side of the sealing body located opposite to the other surface of the sealing body to which the peeling film has been bonded. With this method, the sealing body is integrally held by the peeling film until the sealing member is separated from the sealing body in the separation step. Hence the portion to be the sealing member and the unnecessary portion are not separated until the peeling film is peeled off, so that the sealing body is handled easily.

In one embodiment, the separation step may be performed after the peeling step. With this method, the sealing body is integrally held by the peeling film that is not completely divided until the peeling film is peeled off. It is thereby possible to prevent a shift in the position of the sealing member before the separation step is performed. Therefore, it is possible to improve the positional accuracy of the sealing member at the time when the sealing member is bonded to the electronic device part.

In one embodiment, the method may include a storage step of storing the sealing body after the cutting step and before the separation step, and in the separation step, the sealing member may be separated from the sealing body stored in the storage step. With this method, the sealing body in which a cut is made therein in advance and stored can be used for the manufacturing.

In one embodiment, the method may include a dehydration step of performing a dehydration treatment on the sealing body before the cutting step. With this method, it is possible to prevent moisture from being contained in the sealing member. It is thus possible to prevent the occurrence of a defect in the electronic device due to the moisture contained in the sealing member.

In one embodiment, the method may include a dehydration step of performing a dehydration treatment on the sealing body after the cutting step and before the separation step. With this method, it is possible to prevent moisture from being contained in the sealing member. It is thus possible to prevent the occurrence of a defect in the electronic device due to the moisture contained in the sealing member.

### EFFECT OF THE INVENTION

According to one aspect of the present invention, manufacturing can be simplified.

### BRIEF DESCRIPTION OF THE DRAWINGS

Fig. 1 is a diagram illustrating a cross-sectional configuration of an organic electroluminescence (EL) element manufactured by a method for manufacturing an electronic device according to one embodiment.
Fig. 2 is a flowchart illustrating a method for manufacturing an organic EL element.
Fig. 3 is a diagram illustrating a cross-sectional configuration of a sealing body.
Fig. 4 is a view illustrating a cutting step of a method for manufacturing an organic EL element according to a first embodiment.
Fig. 5 is a diagram illustrating a cross-sectional configuration of a sealing body in which a cut is made in a cutting step.
Fig. 6 is a view illustrating a bonding step of the method for manufacturing an organic EL element according to the first embodiment.
Fig. 7 is a view illustrating a bonding step of the method for manufacturing an organic EL element according to the first embodiment.
Fig. 8 is a view illustrating a cutting step and a bonding step of a method for manufacturing an organic EL element according to a second embodiment.
Fig. 9 is a view illustrating a cutting step and a bonding step of a method for manufacturing an organic EL element according to a third embodiment.
Fig. 10 is a diagram illustrating a cross-sectional configuration of a sealing body in which a cut is made in a cutting step.

### MODE FOR CARRYING OUT THE INVENTION

Hereinafter, preferred embodiments of the present invention will be described in detail with reference to the accompanying drawings. In the description of the drawings, the same or corresponding elements will be denoted by the same reference symbols, and a redundant description will be omitted.

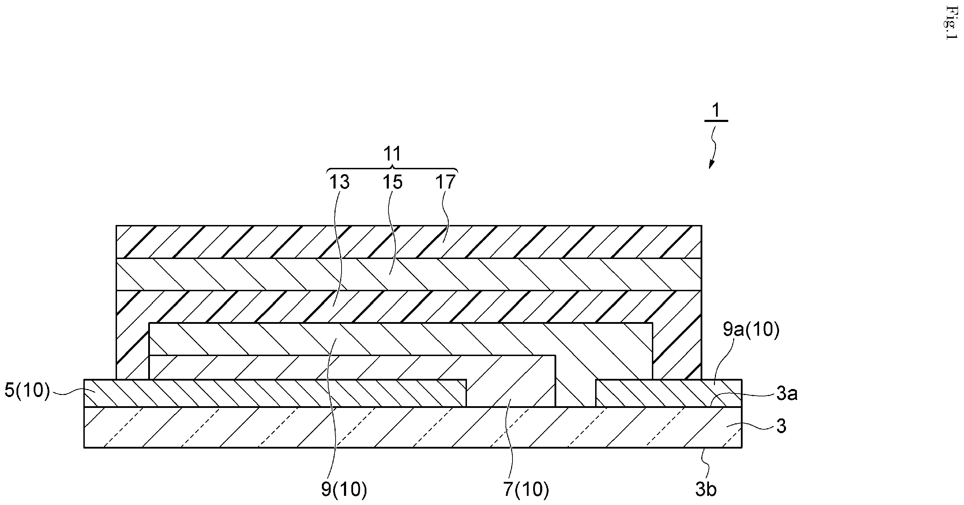

As illustrated in Fig. 1, an organic EL element (electronic device) 1 manufactured by a method for manufacturing an electronic device according to the present embodiment includes a support substrate 3, an anode layer (first electrode layer) 5, an organic functional layer (functional layer) 7, a cathode layer (second electrode layer) 9, and a sealing member 11. The anode layer 5, the organic functional layer 7, and the cathode layer 9 constitute an organic EL part (electronic device part) 10.

### [Support substrate]

The support substrate 3 is made of a resin having translucency to visible light (light with a wavelength between 400 nm and 800 nm). The support substrate 3 is a film-like substrate (a flexible substrate, a substrate having flexibility). The thickness of the support substrate 3 is, for example, 30 µm or more and 500 µm or less. When the support substrate 3 is a resin, the thickness is preferably 45 µm or more from the viewpoint of deflection, wrinkling, and elongation of the substrate during the continuation of a roll-to-roll method, and the thickness is preferably 125 µm or less from the viewpoint of flexibility.

The support substrate 3 is, for example, a plastic film. The material of the support substrate 3 can include, for example, polyethersulfone (PES); polyester resins such as polyethylene terephthalate (PET) and polyethylene naphthalate (PEN); polyolefin resins such as polyethylene (PE), polypropylene (PP), and cyclic polyolefins; polyamide resin; polycarbonate resin; polystyrene resin; polyvinyl alcohol resin; saponified ethylene-vinyl acetate copolymer; polyacrylonitrile resin; acetal resin; polyimide resin; and an epoxy resin.

Among the above resins, the material of the support substrate 3 is preferably polyester resin or polyolefin resin, and more preferably polyethylene terephthalate or polyethylene naphthalate because of high heat resistance, low coefficient of linear expansion, and low manufacturing cost. These resins may be used alone or in a combination of two or more.

On one main surface 3a of the support substrate 3, a gas barrier layer or a moisture barrier layer may be disposed. The other main surface 3b of the support substrate 3 is a light-emitting surface. A light extraction film may be provided on the other main surface 3b. Note that the support substrate 3 may be a thin-film glass. When the support substrate 3 is a thin-film glass, its thickness is preferably 30 µm or more from the viewpoint of strength and 100 µm or less from the viewpoint of flexibility.

### [Anode layer]

The anode layer 5 is disposed on the one main surface 3a of the support substrate 3. As the anode layer 5, an electrode layer exhibiting optical transparency is used. As the electrode exhibiting optical transparency, a thin film of a metal oxide, a metal sulfide, a metal, or the like having a high electric conductivity can be used, and a thin film having a high optical transmittance is used preferably. For example, thin films, formed using indium oxide, zinc oxide, tin oxide, indium tin oxide (abbreviated as ITO), indium zinc oxide (abbreviated as IZO), gold, platinum, silver, copper, or the like is used and among these, the thin film formed using ITO, IZO, or tin oxide is used preferably.

As the anode layer 5, a transparent conductive film of an organic substance such as polyaniline or its derivative, or polythiophene or its derivative may be used. Further, as the anode layer 5, an electrode obtained by patterning the above metal or metal alloy, or the like in a mesh shape, or an electrode in which nanowires containing silver are formed in a network shape may be used.

The thickness of the anode layer 5 can be determined in consideration of optical transparency, electric conductivity, and the like. The thickness of the anode layer 5 is usually from 10 nm to 10 µm, preferably from 20 nm to 1 µm, and more preferably from 50 nm to 200 nm.

Examples of the method of forming the anode layer 5 can include dry film-forming methods such as vacuum evaporation, sputtering, and ion plating, and coating methods such as ink jetting, slit coating, gravure printing, screen printing, and spray coating. A pattern of the anode layer 5 can be formed by photolithography, dry etching, laser trimming, or the like. The pattern can be formed by direct application on the support substrate 3, using a coating method without using the photolithography, the dry etching, the laser trimming, or the like.

### [Organic functional layer]

The organic functional layer 7 is disposed on the main surface of the anode layer 5 (the side opposite to the surface in contact with the support substrate 3). The organic functional layer 7 can include a light-emitting layer. The organic functional layer 7 usually contains a light-emitting material that mainly emits fluorescence and/or phosphorescence, or a dopant material for the light-emitting layer that assists the light-emitting material. The dopant material for the light-emitting layer is added, for example, in order to improve emission efficiency or to change an emission wavelength. Note that the light-emitting material that emits fluorescence and/or phosphorescence may be a low-molecular compound or a high-molecular compound. Examples of the organic substance constituting the organic functional layer 7 can include a light-emitting material emitting fluorescence and/or phosphorescence, such as a dye material, a metal complex material, and a polymer material to be described later, and the dopant material for the light-emitting layer to be described later.

### (Dye material)

Examples of the dye material can include cyclopentamine and its derivatives, tetraphenylbutadiene and its derivatives, triphenylamine and its derivatives, oxadiazole and its derivatives, pyrazoloquinoline and its derivatives, distyrylbenzene and its derivatives, distyrylarylene and its derivatives, pyrrole and its derivatives, thiophene compounds, pyridine compounds, perinone and its derivatives, perylene and its derivatives, oligothiophene and its derivatives, oxadiazole dimers, pyrazoline dimers, quinacridone and its derivatives, and coumarin and its derivatives.

### (Metal complex material)

Examples of the metal complex material can include rare earth metals such as Tb, Eu, and Dy, and metal complexes each having Al, Zn, Be, Pt, Ir or the like as a central metal and having an oxadiazole, thiadiazole, phenylpyridine, phenylbenzimidazole, or quinoline structure, or the like as a ligand. Examples of the metal complex can include a metal complex having light emission from a triplet excited state such as an iridium complex or a platinum complex, an aluminum quinolinol complex, a benzoquinolinol beryllium complex, a benzoxazolyl zinc complex, a benzothiazole zinc complex, an azomethyl zinc complex, a porphyrin zinc complex, and a phenanthroline europium complex.

### (Polymer material)

Examples of the polymer material can include polyparaphenylenevinylene and its derivatives, polythiophene and its derivatives, polyparaphenylene and its derivatives, polysilane and its derivatives, polyacetylene and its derivatives, polyfluorene and its derivatives, polyvinylcarbazole and its derivatives, and a material obtained by polymerizing the above-described dye material or metal complex material.

### (Dopant material for light-emitting layer)

Examples of the dopant material for the light-emitting layer can include perylene and its derivatives, coumarin and its derivatives, rubrene and its derivatives, quinacridone and its derivatives, squarylium and its derivatives, porphyrin and its derivatives, styryl dyes, tetracene and its derivatives, pyrazolone and its derivatives, decacyclene and its derivatives, and phenoxazone and its derivatives.

The thickness of the organic functional layer 7 is usually from 2 nm to 200 nm. The organic functional layer 7 is formed by, for example, a coating method using a coating liquid (e.g., ink) containing the light-emitting material as described above. The solvent of the coating liquid containing the light-emitting material is not limited so long as the solvent dissolves the light-emitting material. In addition, the light-emitting material as described above may be formed by vacuum evaporation.

### [Cathode layer]

The cathode layer 9 is disposed on the main surface of the organic functional layer 7 (the side opposite to the surface in contact with the anode layer 5). As the material of the cathode layer 9, for example, an alkali metal, an alkaline earth metal, a transition metal, a Group 13 metal of the periodic table, and the like can be used. Specific examples of the material of the cathode layer 9 include metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, alloys of two or more of the metals, alloys of one or more of the metals and one or more of gold, silver, platinum, copper, manganese, titanium, cobalt, nickel, tungsten, and tin, graphite, and interlayer compounds of graphite. Examples of the alloys can include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

As the cathode layer 9, for example, a transparent conductive electrode formed using a conductive metal oxide, a conductive organic substance, or the like can be used. Specific examples of the conductive metal oxide include indium oxide, zinc oxide, tin oxide, ITO, and IZO, and examples of the conductive organic substance include polyaniline and its derivatives, and polythiophene and its derivatives. Note that the cathode layer 9 may be made up of a laminate in which two or more layers are laminated. Note that an electron injection layer to be described later may be used as the cathode layer 9 in some cases.

The thickness of the cathode layer 9 is set in consideration of electric conductivity and durability. The thickness of the cathode layer 9 is usually from 10 nm to 10 µm, preferably from 20 nm to 1 µm, and more preferably from 50 nm to 500 nm.

Examples of the method of forming the cathode layer 9 can include coating methods such as ink jetting, slit coating, gravure printing, screen printing, and spray coating, vacuum evaporation, sputtering, and a lamination method for performing thermocompression bonding on a metal thin film, and vacuum evaporation or sputtering is preferred.

The cathode layer 9 may have a lead-out part (second electrode layer) 9a. The lead-out part 9a is disposed on the one main surface 3a of the support substrate 3. Specifically, the lead-out part 9a is disposed on the one main surface 3a of the support substrate 3 while separated (electrically insulated) from the anode layer 5. The lead-out part 9a is electrically connected to the cathode layer 9. The lead-out part 9a can be formed using the same material and the same forming method as those for the anode layer 5.

### [Sealing member]

The sealing member 11 is disposed at the uppermost part in the organic EL element 1. The sealing member 11 has an adhesive part 13, a sealing base material 15, and a protective part 17. The sealing member 11 is laminated in the order of the adhesive part 13, the sealing base material 15, and the protective part 17.

The adhesive part 13 is used for bonding the sealing base material 15 and the protective part 17 to the organic EL part 10 including the anode layer 5, the organic functional layer 7, and the cathode layer 9. The adhesive part 13 is specifically made of a photo-curable or thermosetting acrylate resin or a photo-curable or thermosetting epoxy resin. Other commonly used resin films that can be fused with an impulse sealer, for example, a heat-fusible film such as ethylene vinyl acetate copolymer (EVA), a polypropylene (PP) film, a polyethylene (PE) film, a polybutadiene (PB) film, or the like, can also be used. A thermoplastic resin can also be used.

The sealing base material 15 is formed using a metal foil, a transparent plastic film, a thin-film glass having flexibility, or the like. As the metal foil, copper, aluminum, or stainless steel is preferred from the viewpoint of barrier properties. The thickness of the metal foil is preferably as large as possible from the viewpoint of suppressing pinholes, but when the viewpoint of flexibility is also considered, the thickness is preferably from 10 µm to 50 µm. The protective part 17 is, for example, a plastic film. Examples of the material of the protective part 17 can include polyester resins such as PES, PET, and PEN. The thickness of the protective part 17 may be a thickness to the extent that does not impair flexibility, and is, for example, 5 µm to 200 µm.

### [Method for manufacturing organic EL element]

### (First Embodiment)

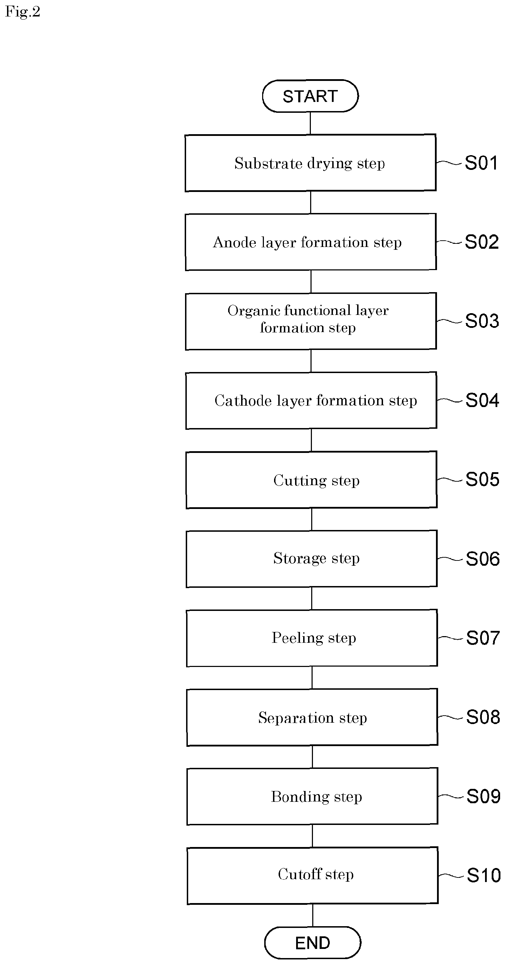

Subsequently, a method for manufacturing an organic EL element 1 having the above-described configuration according to a first embodiment will be described with reference to Fig. 2.

In a mode in which the support substrate 3 is a substrate having flexibility and extending in the longitudinal direction (one direction), a roll-to-roll method can be adopted. In the case of manufacturing the organic EL element 1 by the roll-to-roll method, each layer is formed in order from the long flexible support substrate 3 stretched between an unwinding roll (not illustrated) and a winding roll (not illustrated), while the support substrate 3 is continuously carried by a conveying roller (not illustrated).

As illustrated in Fig. 2, in the case of manufacturing the organic EL element 1, the support substrate 3 is heated and dried (substrate drying step S01). Next, the anode layer 5 is formed on the one main surface 3a of the dried support substrate 3 (anode layer formation step (formation step) S02). The anode layer 5 can be formed by the formation method exemplified in the description of the anode layer 5. At the same timing as the formation of the anode layer 5, the lead-out part 9a is formed. The lead-out part 9a can be formed by the forming method exemplified in the description of the lead-out part 9a (the same forming method as that for the anode layer 5).

On the support substrate 3, a plurality of pairs of the anode layer 5 and the lead-out part 9a are formed at predetermined intervals in the longitudinal direction of the support substrate 3, and a plurality of (e.g., two) pairs are formed at predetermined intervals in the width direction (another direction orthogonal to the one direction) of the support substrate 3.

Subsequently, the organic functional layer 7 is formed on the anode layer 5 (organic functional layer formation step (formation step) S03). The organic functional layer 7 can be formed by the formation method exemplified in the description of the organic functional layer 7. Next, the cathode layer 9 is formed on the organic functional layer 7 and the lead-out part 9a (cathode layer formation step (formation step) S04). The cathode layer 9 can be formed by the formation method exemplified in the description of the cathode layer 9. As described above, on the one main surface 3a of the support substrate 3, a plurality of organic EL parts 10 are formed at predetermined intervals in the longitudinal direction of the support substrate 3, and are formed at predetermined intervals in the width direction of the support substrate 3. That is, a plurality of rows (e.g., two rows) of the organic EL parts 10 are formed along the longitudinal direction of the support substrate 3.

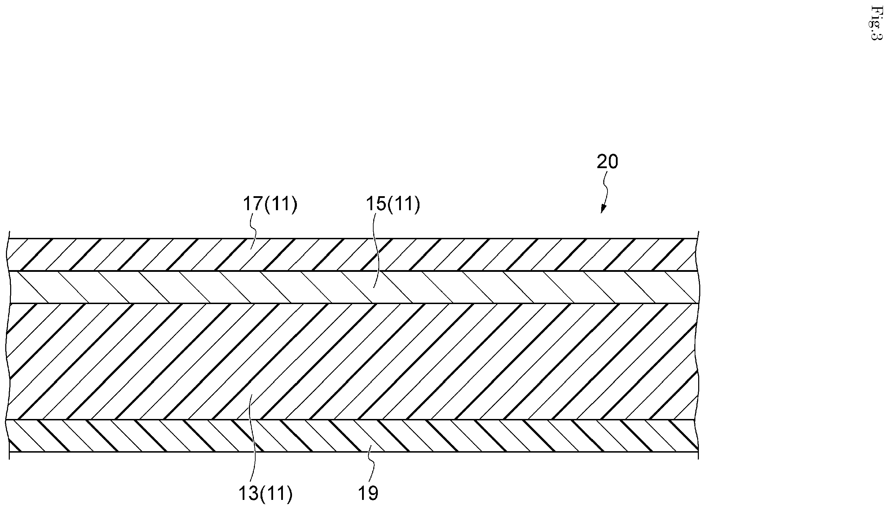

Subsequently, a sealing body 20 is prepared, and a cut is made in the sealing body 20 (cutting step S05). The sealing body 20 is a parent material of the sealing member 11. As illustrated in Fig. 3, the sealing body 20 has a separate film (peeling film) 19, in addition to the adhesive part 13, the sealing base material 15, and the protective part 17 that constitute the sealing member 11. The separate film 19 has been bonded to the adhesive surface of the adhesive part 13. The separate film 19 is, for example, a plastic film. Examples of the material of the separate film 19 can include polyester resins such as PES, PET, and PEN. The thickness of the separate film 19 may be a thickness with a strength that does not break against tension for winding the separate film 19 and a thickness that does not impair flexibility, and the thickness of the separate film 19 is, for example, 10 µm to 200 µm.

The width of the sealing body 20 is larger than the width of the sealing member 11. That is, the dimension in the width direction orthogonal to the longitudinal direction of the sealing body 20 is larger than the dimension in the width direction of the sealing member 11. In the present embodiment, for example, the width of the sealing body 20 is at least twice the width of the sealing member 11. In the cutting step S05, in the sealing body 20, a cut is made so that the width of the sealing member 11 obtained from the sealing body 20 is a width with which a portion of each of the anode layer 5 and the lead-out part 9a of the cathode layer 9 in the organic EL part 10 is exposed.

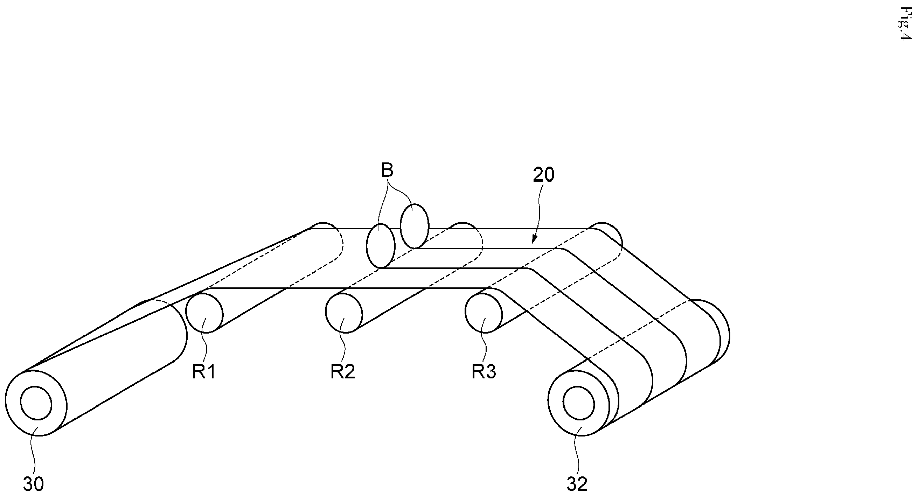

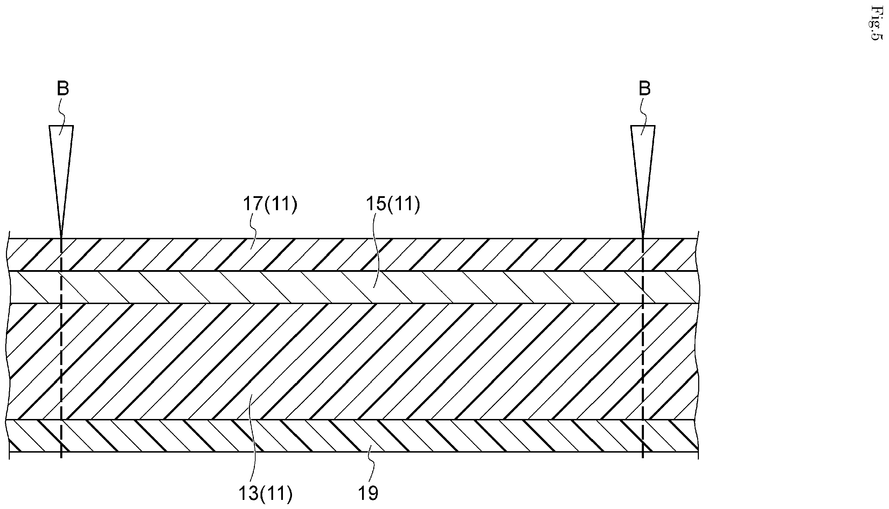

As illustrated in Fig. 4, in the cutting step S05, a cut is made in the sealing body 20 with a cutting blade B. The cutting blade B is, for example, a rotary blade. In the cutting step S05, for example, while the long sealing body 20, stretched between a winding roll 32 and an unwinding roll 30 wound with the sealing body 20, is continuously conveyed by a conveying roller R1, a conveying roller R2, and a conveying roller R3, a cut is made in the sealing body 20 with a cutting blade B. In the present embodiment, two cuts in the sealing body 20 are made with two cutting blades B at a predetermined interval in the width direction at a position near the center of the sealing body 20. At this time, as illustrated in Fig. 5, the cuts are made with the cutting blades B in the sealing body 20 from one surface side located opposite to the other surface to which the separate film 19 has been bonded, that is, from the protective part 17 side. The cuts are made so that the sealing member 11 can be separated from the sealing body 20 in the separation step S08 to be described later. Specifically, the cuts are made across the adhesive part 13, the sealing base material 15, the protective part 17, and the separate film 19. In the present embodiment, the cuts are made in the separate film 19 so as to be completely divided in the thickness direction. The sealing body 20 in which the cuts have been made is wound around the winding roll 32.

Subsequently, as illustrated in Fig. 2, the winding roll 32 of the sealing body 20 in which the cuts have been made is stored (storage step S06). In the present embodiment, for example, the winding roll 32 is stored in a storage. The storage is preferably, for example, an environment having a low moisture concentration.

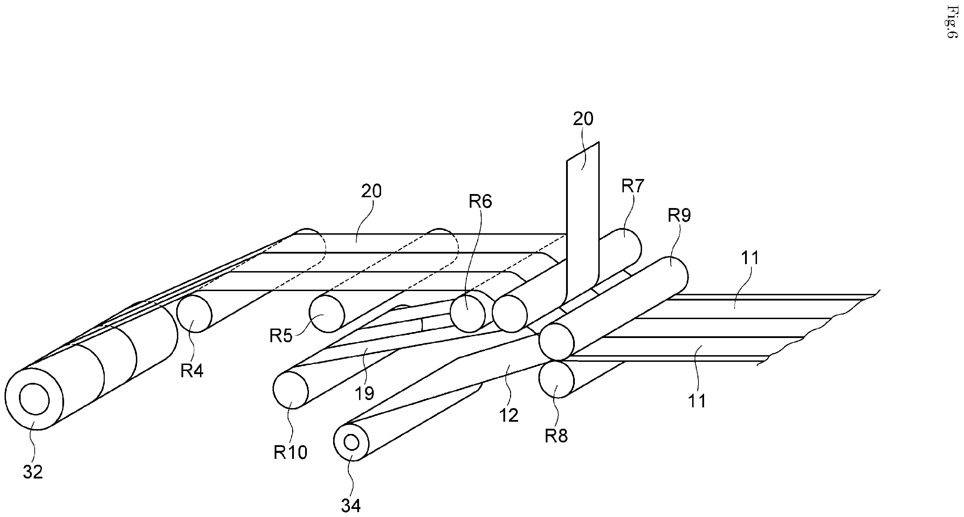

Then, as illustrated in Fig. 2, the winding roll 32 stored in the storage step S06 is prepared, and the separate film 19 is peeled off from the sealing body 20 (peeling step S07). As illustrated in Fig. 6, while the sealing body 20 is continuously unwound from the winding roll 32 and the sealing body 20 is conveyed by a conveying roller R4, a conveying roller R5, and a conveying roller R6, the separate film 19 is peeled off from the sealing body 20. More specifically, in the sealing body 20, the separate film 19 bonded to the portion for use as the sealing member 11 is peeled off. The separate film 19 having been peeled off is wound around, for example, a roller R10. Note that the sealing body 20 unwound from the winding roll 32 is conveyed in a state where each of the parts (a portion for use as the sealing member 11 and an unnecessary portion (described later)) is held integrally. Tension is applied to the sealing body 20 in the conveying direction. This prevents the sealing member 11 from moving in a direction in which the sealing body 20 is separated from the conveying roller R4, the conveying roller R5, and the conveying roller R6. Further, each of the above-described parts of the sealing body 20 has a thickness, and hence the movement in the width direction is restricted by each of the parts. Thus, each part of the sealing body 20 unwound from the winding roll 32 is not separated. For this reason, the sealing body 20 is conveyed in the state where each part is held integrally.

Before the peeling step S07, the sealing body 20 stored in the storage step S06 may be subjected to a dehydration treatment (dehydration step). In the dehydration treatment, the sealing body 20 is heated. As an apparatus for heating the sealing body 20, an apparatus that irradiates the sealing body 20 with infrared rays, an apparatus that supplies hot air, a heating roller that contacts the sealing body 20, an oven, or the like can be used. The dehydration treatment for the sealing body 20 is preferably performed in a nitrogen atmosphere.

Subsequently, as illustrated in Fig. 2, the sealing member 11 is separated from the sealing body 20 from which the separate film 19 has been peeled off (separation step S08). Specifically, in the sealing body 20 from which the separate film 19 has been peeled off, the sealing member 11 and an unnecessary portion (a portion except for a portion for use as the sealing member 11) are separated along the cuts made in the cutting step S05, and the unnecessary portion is removed. As illustrated in Fig. 6, in the separation step S08, the unnecessary portion of the sealing body 20 is removed from the winding roll 32 via the roller R7. The removed unnecessary portion of the sealing body 20 is wound around, for example, a roller (not illustrated). Thereby, the sealing member 11 is separated from the sealing body 20.

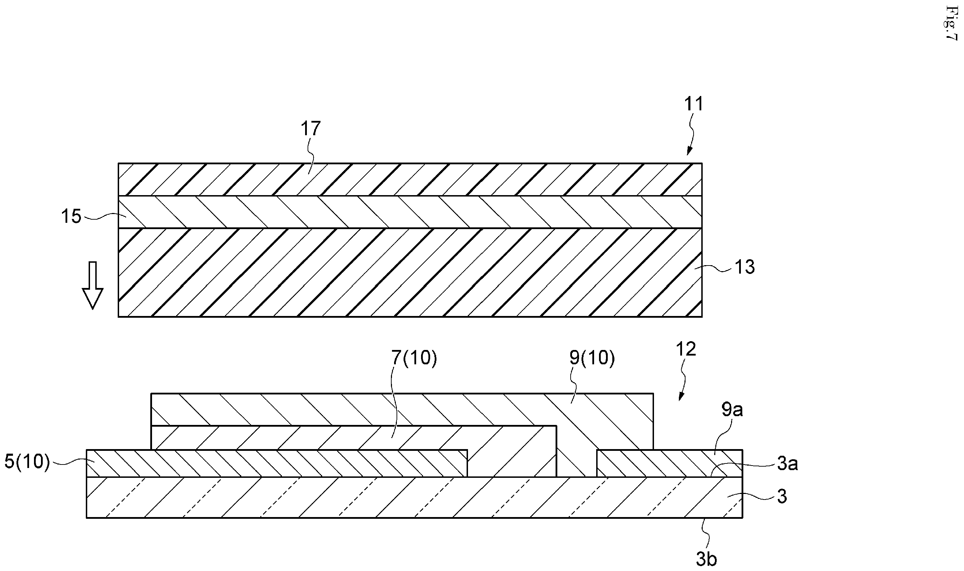

Subsequently, as illustrated in Fig. 2, the sealing member 11 is bonded to the organic EL part 10 (bonding step S09). Specifically, as illustrated in Fig. 7, the sealing member 11 is stuck on the organic EL part 10 such that a portion of the anode layer 5 and a portion of the lead-out part 9a of the cathode layer 9 are exposed and that the sealing member 11 straddles the plurality of organic EL parts 10. Specifically, the sealing member 11 is stuck along the longitudinal direction so as to straddle the plurality of organic EL parts 10.

As illustrated in Fig. 6, in the roll-to-roll method, while the support substrate 12 on which the organic EL part 10 has been formed (hereinafter, the support substrate 12 with the organic EL part) is unwound from an unwinding roll 34 and the support substrate 12 with the organic EL part is conveyed, the organic EL part 10 and the sealing member 11 are bonded to each other. The support substrate 12 with the organic EL part and the sealing member 11 pass between a roller R8 and a roller R9. Thereby, pressure is applied to the support substrate 12 with the organic EL part and the sealing member 11 by the roller R8 and the roller R9 to bring the adhesive part 13 and the organic EL part 10 into close contact. Note that a heating mechanism may be provided for the roller R8 and the roller R9 or for the roller R8 or the roller R9. When the organic EL part 10 and the sealing member 11 are bonded, the bonding is preferably performed in an environment having a low moisture concentration, particularly preferably in a nitrogen atmosphere.

Note that the alignment of the sealing member 11 with respect to the organic EL part 10 is performed by detecting the positional information of the end in the width direction of the support substrate 12 with the organic EL part, detecting the positional information of the end in the width direction of the sealing body 20, and moving the support substrate 12 with the organic EL part or the sealing body 20 in the width direction of the support substrate 12 with the organic EL part or the sealing body 20 based on the positional information of each end.

Subsequently, as illustrated in Fig. 2, the plurality of organic EL parts 10 to which the sealing member 11 has been bonded are made into individual pieces (cutoff step S10). In the above manner, the organic EL element 1 illustrated in Fig. 1 is manufactured.

As described above, in the method for manufacturing the organic EL element 1 according to the first embodiment, cuts are made in the sealing body 20 in the cutting step S05, and the sealing member 11 is separated from the sealing body 20 in the separation step S08 before the sealing member 11 is bonded to the organic EL part 10 in the bonding step S09. Then, the sealing member 11 separated from the sealing body 20 is bonded. Hence in the method for manufacturing the organic EL element 1, it is not necessary to remove the unnecessary portion after the bonding of the sealing member 11. Therefore, the method for manufacturing the organic EL element 1 can simplify the manufacturing.

In the method for manufacturing the organic EL element 1 according to the present embodiment, the sealing member is treated as a single sealing body 20 including a plurality of sealing members 11 until just before the sealing member 11 is bonded to the organic EL part 10 in the bonding step S09. Therefore, when the organic EL parts 10 are formed in a plurality of rows in the width direction of the support substrate 12 with the organic EL part, the sealing member 11 can be aligned with the organic EL part 10 at once by aligning the sealing body 20 with the support substrate 12 with the organic EL part. Hence there is no need to align the sealing members 11 with the organic EL part 10 line by line, so that the manufacturing process and apparatus can be simplified.

In the method for manufacturing the organic EL element 1 according to the present embodiment, the sealing body 20 provided with the separate film 19 is used. The method for manufacturing the organic EL element 1 according to the present embodiment includes the peeling step S07 of peeling off the separate film 19 from the sealing body 20 after the cutting step S05 (storage step S06) and before the bonding step S09. With this method, the separate film 19 is stuck to the sealing body 20 until the sealing member 11 is bonded. Therefore, adhesion of dust or the like to the sealing member 11 can be prevented. As a result, it is possible to prevent the occurrence of a defect in the organic EL element 1 due to dust or the like.

The method for manufacturing the organic EL element 1 according to the present embodiment includes the storage step S06 of storing the sealing body 20 after the cutting step S05 and before the separation step S08 (peeling step S07). In the separation step S08, the sealing member 11 is separated from the sealing body 20 stored in the storage step S06. With this method, the sealing body 20, in which the cuts have been made and which has been stored in advance, can be used for the manufacturing.

In the method for manufacturing the organic EL element 1 according to the present embodiment, a dehydration treatment is performed on the sealing body 20 after the cutting step S05 and before the separation step S08. With this method, the sealing member 11 can be prevented from containing moisture. It is thus possible to prevent the occurrence of a defect in the organic EL element 1 due to the moisture contained in the sealing member 11.

### (Second Embodiment)

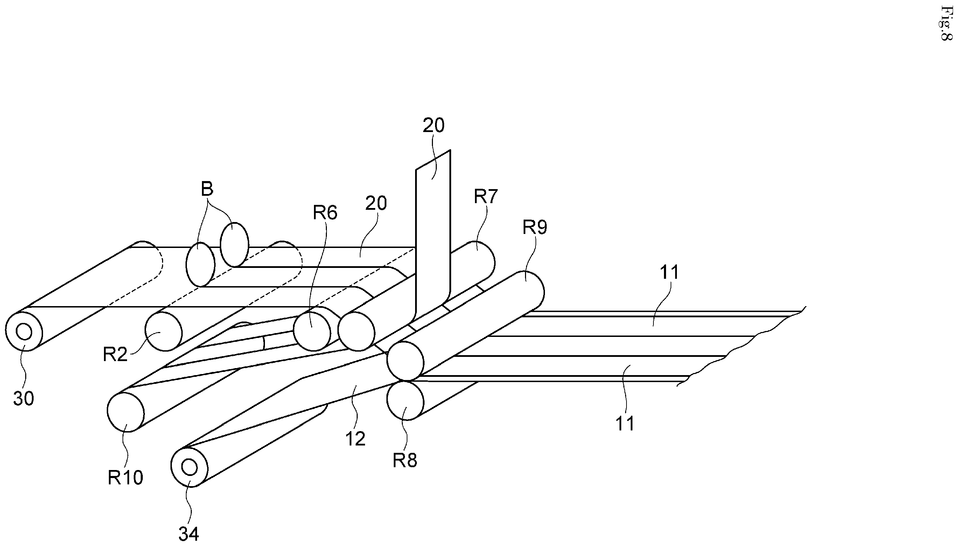

Subsequently, a method for manufacturing the organic EL element 1 according to a second embodiment will be described with reference to Fig. 8. In the method for manufacturing the organic EL element 1 according to the second embodiment, steps from the substrate drying step S01 to the cathode layer formation step S04 are the same as those in the first embodiment.

In the method for manufacturing the organic EL element 1 according to the second embodiment, a cutting step, a peeling step, a separation step, and a bonding step are performed continuously. As illustrated in Fig. 8, in the cutting step, while the sealing body 20 is continuously unwound from the unwinding roll 30 wound with the sealing body 20 and the sealing body 20 is conveyed by the conveying rollers R2 and the conveying roller R6, cuts are made in the sealing body 20 with the cutting blades B.

Then, in the peeling step, the separate film 19 is peeled off from the sealing body 20. As illustrated in Fig. 8, the separate film 19 is peeled off from the sealing body 20 in which the cuts have been made. More specifically, in the sealing body 20, the separate film 19 bonded to the portion for use as the sealing member 11 is peeled off. The separate film 19 having been peeled off is wound around, for example, a roller R10. Note that the sealing body 20 in which the cuts have been made is conveyed in a state where each of the parts (a portion for use as the sealing member 11 and an unnecessary portion) is held integrally. Tension is applied to the sealing body 20 in the conveying direction. This prevents the sealing member 11 from moving in a direction in which the sealing body 20 is separated from the conveying roller R6. Further, each of the above-described parts of the sealing body 20 has a thickness, and hence the movement in the width direction is restricted by each of the parts. Thus, each part of the sealing body 20 unwound from the winding roll 32 is not separated. For this reason, the sealing body 20 is conveyed in the state where each part is held integrally.

Subsequently, in the separation step, the sealing member 11 is separated from the sealing body 20 from which the separate film 19 has been peeled off. Specifically, in the sealing body 20 from which the separate film 19 has been peeled off, the sealing member 11 and an unnecessary portion are separated along the cuts made in the cutting step, and the unnecessary portion is removed. As illustrated in Fig. 8, the unnecessary portion of the sealing body 20 is removed via the roller R7. The removed unnecessary portion of the sealing body 20 is wound around, for example, a roller (not illustrated). Thereby, the sealing member 11 is separated from the sealing body 20.

Subsequently, in the bonding step, the sealing member 11 is bonded to the organic EL part 10. Specifically, the sealing member 11 is stuck on the organic EL part 10 such that a portion of the anode layer 5 and a portion of the lead-out part 9a of the cathode layer 9 are exposed and that the sealing member 11 straddles the plurality of organic EL parts 10. Then, the plurality of organic EL parts 10 to which the sealing member 11 has been bonded are made into individual pieces. In the above manner, the organic EL element 1 illustrated in Fig. 1 is manufactured.

As described above, in the method for manufacturing the organic EL element 1 according to the second embodiment, as in the first embodiment, cuts are made in the sealing body 20 in the cutting step S05, and the sealing member 11 is separated from the sealing body 20 before the sealing member 11 is bonded to the organic EL part 10 in the bonding step S09. Then, the sealing member 11 separated from the sealing body 20 is bonded. Hence in the method for manufacturing the organic EL element 1, it is not necessary to remove the unnecessary portion after the bonding of the sealing member 11. Therefore, the method for manufacturing the organic EL element 1 can simplify the manufacturing.

Further, in the method for manufacturing the organic EL element 1 according to the present embodiment, the cutting step, the peeling step, the separation step, and the bonding step are performed continuously. Therefore, an apparatus or the like necessary for temporarily winding the member (e.g., an apparatus for manufacturing a winding roll) is not required, so that the apparatus can be simplified.

### (Third Embodiment)

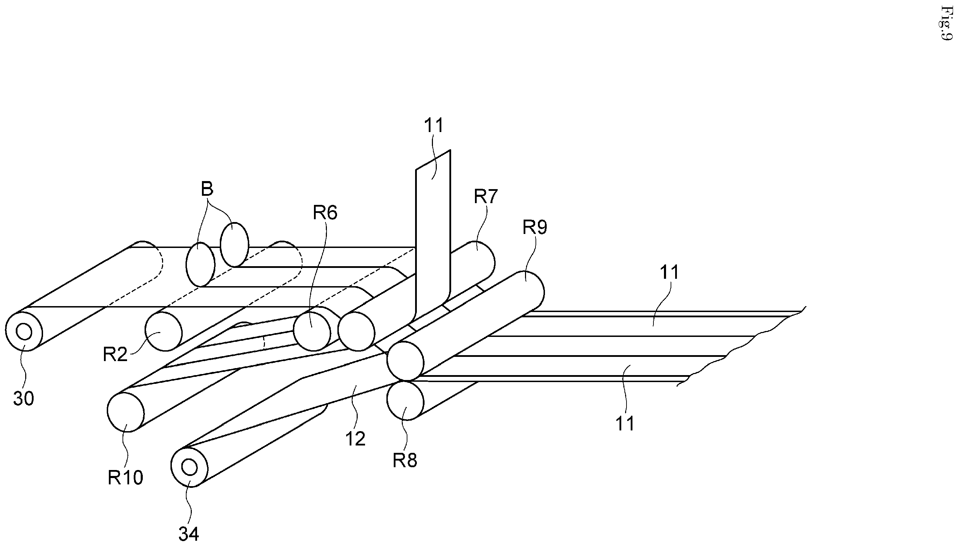

Subsequently, a method for manufacturing the organic EL element 1 according to a third embodiment will be described with reference to Fig. 9. In the method for manufacturing the organic EL element 1 according to the third embodiment, steps from the substrate drying step S01 to the cathode layer formation step S04 are the same as those in the first embodiment.

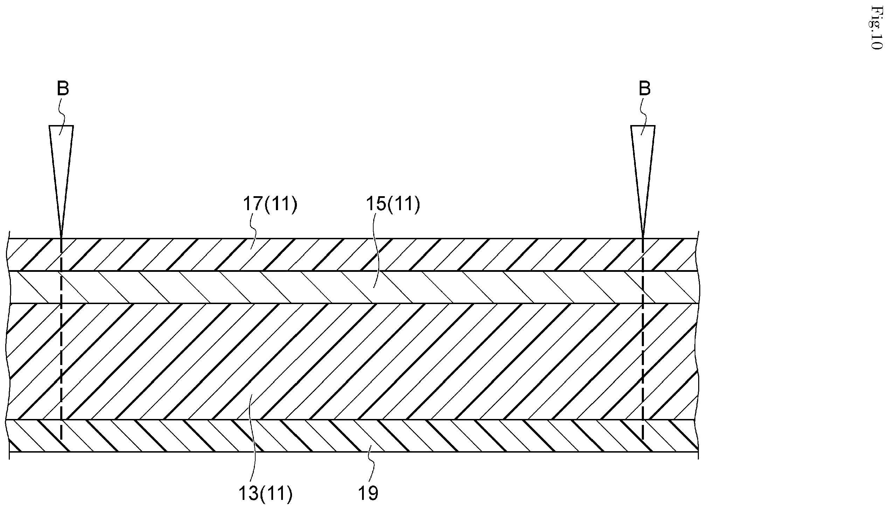

In the method for manufacturing the organic EL element 1 according to the third embodiment, a cutting step, a peeling step, a separation step, and a bonding step are performed continuously. As illustrated in Fig. 9, in the cutting step, cuts are made in the sealing body 20 with the cutting blades B, while the sealing body 20 is continuously unwound from the unwinding roll 30 wound with the sealing body 20, and conveyed by a conveying roller R2 and the conveying roller R6. As illustrated in Fig. 10, in the cutting step, the cuts are made with the cutting blades B in the sealing body 20 from one surface side located opposite to the other surface side to which the separate film 19 has been bonded, that is, from the protective part 17 side. The cuts are made so that the sealing member 11 can be separated from the sealing body 20 in the separation step to be described later. Specifically, the cuts are made across the adhesive part 13, the sealing base material 15, the protective part 17, and the separate film 19. In the present embodiment, the cuts are made in the separate film 19 so as not to be completely divided in the thickness direction. In Fig. 10, each cut is made in the separate film 19 so as to be a half-cut, but no cut may be made in the separate film 19. The depth of the cut in the separate film 19 may be a depth with which the separate film 19 is not completely divided, and may be, for example, 0.01 to 0.99 times the thickness of the separate film 19.

Then, in the peeling step, the separate film 19 is peeled off from the sealing body 20. As illustrated in Fig. 9, the separate film 19 is peeled off from the sealing body 20 in which the cuts have been made. More specifically, all the separate films 19 bonded to the sealing body 20 are peeled off. The separate film 19 having been peeled off is wound around, for example, a roller R10.

Subsequently, in the separation step, the sealing member 11 is separated from the sealing body 20. Specifically, in the sealing body 20, the sealing member 11 and an unnecessary portion are separated, and the unnecessary portion is removed. As illustrated in Fig. 9, the unnecessary portion (sealing member 11) of the sealing body 20 is removed via the roller R7. The removed unnecessary portion of the sealing body 20 is wound around, for example, a roller (not illustrated). Thereby, the sealing member 11 is separated from the sealing body 20.

Subsequently, in the bonding step, the sealing member 11 is bonded to the organic EL part 10. Specifically, the sealing member 11 is stuck on the organic EL part 10 such that a portion of the anode layer 5 and a portion of the lead-out part 9a of the cathode layer 9 are exposed and that the sealing member 11 straddles the plurality of organic EL parts 10. Then, the plurality of organic EL parts 10 to which the sealing member 11 has been bonded are made into individual pieces. In the above manner, the organic EL element 1 illustrated in Fig. 1 is manufactured.

As described above, in the method for manufacturing the organic EL element 1 according to the third embodiment, as in the first embodiment, cuts are made in the sealing body 20 in the cutting step S05, and the sealing member 11 is separated from the sealing body 20 before the sealing member 11 is bonded to the organic EL part 10 in the bonding step S09. Then, the sealing member 11 separated from the sealing body 20 is bonded. Hence in the method for manufacturing the organic EL element 1, it is not necessary to remove the unnecessary portion after the bonding of the sealing member 11. Therefore, the method for manufacturing the organic EL element 1 can simplify the manufacturing.

In the method for manufacturing the organic EL element 1 according to the third embodiment, in the cutting step, cuts are made so that the separate film 19 is not divided in the thickness direction of the separate film 19 from one surface side of the sealing body 20 located opposite to the other surface thereof to which the separate film 19 has been bonded. With this method, the sealing body 20 is integrally held by the separate film 19 until the sealing member 11 is separated from the sealing body 20 in the separation step. Hence the portion to be the sealing member 11 and the unnecessary portion are not separated, so that the sealing body 20 is handled easily.

In the method for manufacturing the organic EL element 1 according to the third embodiment, the separation step is performed after the peeling step. With this method, the sealing body 20 is integrally held by the separate film 19 that is not completely divided until the separate film 19 is peeled off. It is thereby possible to prevent a shift in the position of the sealing member 11 before the separation step is performed. Therefore, it is possible to improve the positional accuracy of the sealing member 11 at the time when the sealing member 11 is bonded to the organic EL part 10.

In the third embodiment, the sealing body 20 in which the cuts have been made may be wound to form a winding roll, and the winding roll may be stored. In this case, in the peeling step, the stored winding roll is prepared, and the separate film 19 is peeled off from the sealing body 20.

In the conventional method for manufacturing an organic EL element, a method may also be adopted in which in the bonding step, a band-shaped sealing member is unwound from a roll where a sealing member having a predetermined width (a width with which a portion of the anode layer 5 and a portion of the lead-out part 9a of the cathode layer 9 in the organic EL part 10 are exposed) has been wound in advance, and the sealing member is bonded. However, the method may cause the following problems.

The band-shaped sealing member generally meanders during conveyance, and hence it is not easy to convey the sealing member such that the interval between the plurality of sealing members is maintained. Therefore, when the above method is adopted, in order to convey the sealing member such that a constant interval is maintained in the plurality of sealing members, an apparatus (steering roll, etc.) for moving the meandering sealing member to a predetermined position is required for each band-shaped sealing member. Therefore, in the above method, the configuration of the manufacturing apparatus is complicated and increased in size, and a space for installing the manufacturing apparatus is also required.

Further, the meandering of the sealing member may be prevented by a side guide or the like that defines the position in the width direction of the sealing member. However, the sealing member can be deformed when coming into contact with the side guide or the like. In particular, when the sealing member is formed using a metal foil having a high sealing function, the sealing member is deformed easily. The deformation of the sealing member causes a short circuit in the organic EL element. Therefore, when the sealing member is formed using a metal foil, a large apparatus such as a steering roll is required instead of the side guide or the like. For bonding the band-shaped sealing member to the organic EL part so as to straddle each of the plurality of organic EL parts (electronic device parts) formed at predetermined intervals, it is necessary to dispose such a large-sized apparatus for every band-shaped sealing member to prevent meandering, thereby further increasing the size of the apparatus. An increase in size of the apparatus leads to an increase in size of a chamber in a step requiring a reduced pressure condition, a vacuum condition, or an inert gas atmosphere. Therefore, when the above method is adopted, the apparatus cost and manufacturing cost increase.

In contrast, in the method for manufacturing the organic EL element 1 according to the present invention, the method of unwinding the sealing member 11 from a roll wound with the sealing member 11 having a predetermined width in advance is not used, and hence the apparatus (steering roll, etc.) for moving the meandering sealing member to a predetermined position as thus described is not necessarily required. For example, when the embodiment illustrated in Fig. 8 (second embodiment) or Fig. 9 (third embodiment) is adopted, the position of the sealing member to be bonded to the organic EL part can be determined such that the sealing member straddles each of the plurality of organic EL parts formed with predetermined intervals by adjusting the position of the cutting blade B, whereby it is possible to omit the apparatus (steering roll, etc.) for moving the meandering sealing member to a predetermined position as thus described. Therefore, with the method for manufacturing the organic EL element 1 according to the present invention, it is possible to simplify the manufacturing and reduce the manufacturing cost.

Although the embodiments of the present invention have been described above, the present invention is not necessarily limited to the embodiments described above, and various changes can be made without departing from the gist of the present invention.

For example, in the above embodiments, the organic EL element 1 has been exemplified where the organic functional layer 7 including the light-emitting layer is disposed between the anode layer 5 and the cathode layer 9. However, the configuration of the organic functional layer 7 is not limited thereto. The organic functional layer 7 may have the following configuration:
(a) (anode layer)/light-emitting layer/(cathode layer)
(b) (anode layer)/hole injection layer/light-emitting layer/(cathode layer)
(c) (anode layer)/hole injection layer/light-emitting layer/electron injection layer/(cathode layer)
(d) (anode layer)/hole injection layer/light-emitting layer/electron transport layer/electron injection layer/(cathode layer)
(e) (anode layer)/hole injection layer/hole transport layer/light-emitting layer/(cathode layer)
(f) (anode layer)/hole injection layer/hole transport layer/light-emitting layer/electron injection layer/(cathode layer)
(g) (anode layer)/hole injection layer/hole transport layer/light-emitting layer/electron transport layer/electron injection layer/(cathode layer)
(h) (anode layer)/light-emitting layer/electron injection layer/(cathode layer)
(i) (anode layer)/light-emitting layer/electron transport layer/electron injection layer/(cathode layer)

Here, symbol "/" represents that layers sandwiching symbol "/" are laminated adjacently. The configuration shown in (a) above shows the configuration of the organic EL element 1 in the above embodiments.

Known materials can be used for the respective materials of the hole injection layer, the hole transport layer, the electron transport layer, and the electron injection layer. Each of the hole injection layer, the hole transport layer, the electron transport layer, and the electron injection layer can be formed by, for example, a coating method similarly to the organic functional layer 7.

Here, the electron injection layer may contain an alkali metal or an alkaline earth metal, or an oxide or a fluoride of the alkali metal or the alkaline earth metal. Examples of the method for forming the electron injection layer can include a coating method and vacuum evaporation. In the cases of the oxide and the fluoride, the thickness of the electron injection layer is preferably from 0.5 nm to 20 nm. The electron injection layer is preferably a thin film from the viewpoint of preventing an increase in the driving voltage of the organic EL element 1 when the insulating property is particularly strong, and the thickness of the electron injection layer is, for example, 0.5 nm to 10 nm, and is preferably 2 nm to 7 nm from the viewpoint of electron injection properties.

The organic EL element 1 may have a single organic functional layer 7 or may have two or more organic functional layers 7. When the laminated structure disposed between the anode layer 5 and the cathode layer 9 in any one of the layer configurations of (a) to (i) above is defined as a "structural unit A", examples of the configuration of the organic EL element having two organic functional layers 7 can include a layer configuration shown in (j) below. The layer configurations of two (structural units A) may be the same or different.
(j) anode layer/(structural unit A)/charge generation layer/(structural unit A)/cathode layer

Here, the charge generation layer is a layer that generates holes and electrons by applying an electric field. Examples of the charge generation layer can include a thin film formed using vanadium oxide, ITO, molybdenum oxide, or the like.

When "(structural unit A)/charge generation layer" is defined as a "structural unit B", examples of the configuration of the organic EL element having three or more organic functional layers 7 can include a layer configuration shown in (k) below:
(k) anode layer/(structural unit B) x/(structural unit A)/cathode layer

Symbol "x" represents an integer of 2 or more, and "(structural unit B)x" represents a laminate in which x (structural units B) are laminated. The layer configurations of the plurality of (structural units B) may be the same or different.

An organic EL element may be configured by directly laminating a plurality of organic functional layers 7 without providing a charge generation layer.

In the above embodiments, the mode in which the first electrode layer is the anode layer 5 and the second electrode layer is the cathode layer 9 has been described as an example. However, the first electrode layer may be the cathode layer and the second electrode layer may be the anode layer.

In the above embodiments, the mode in which the anode layer 5 is formed on the support substrate 3 has been described as an example. However, a roll in which the anode layer 5 is formed in advance on the support substrate 3 may be used.

In the above embodiments, the mode has been described as an example in which the step of heating and drying the support substrate 3 in the method for manufacturing the organic EL element 1 is performed. However, the step of drying the support substrate 3 does not necessarily have to be performed.

In the above embodiments, the mode has been described as an example in which, on the support substrate 3, a plurality of organic EL parts 10 are formed at predetermined intervals in the longitudinal direction of the support substrate 3, and a plurality of organic EL parts 10 are formed at predetermined intervals in the width direction of the support substrate 3. That is, the mode in which a plurality of rows of the organic EL parts 10 are formed on the support substrate 3 has been described as an example. However, at least one row of the organic EL parts 10 may be formed on the support substrate 3.

In the above embodiments, the mode has been described as an example in which the alignment of the sealing member 11 with respect to the organic EL part 10 is performed by detecting the positional information of the end in the width direction of the support substrate 12 with the organic EL part, detecting the positional information of the end in the width direction of the sealing body 20, and moving the support substrate 12 with the organic EL part or the sealing body 20 in the width direction of the support substrate 12 with the organic EL part or the sealing body 20 based on the positional information of each end. However, the method of aligning the sealing member 11 with respect to the organic EL part 10 is not limited thereto. For example, the alignment of the sealing member 11 with respect to the organic EL part 10 may be performed by detecting positional information of an alignment mark provided on the support substrate 12 with the organic EL part based on the image of the alignment mark captured by a camera, detecting positional information of an alignment mark provided on the sealing body 20 based on the image of the alignment mark captured by the camera, and moving at least one of the support substrate 12 with the organic EL part and the sealing body 20 in the width direction of the support substrate 12 with the organic EL part or the sealing body 20 based on the positional information of each alignment mark.

The alignment of the sealing member 11 with respect to the organic EL part 10 may be performed based on detection results obtained by detecting the positional information of the end in the width direction of the support substrate 12 with the organic EL part and detecting the positional information of the alignment mark provided on the sealing body 20, or based on detection results obtained by detecting the positional information of the alignment mark provided on the support substrate 12 with the organic EL part and positional information of the end in the width direction of the sealing body 20. The positional information of the end in the width direction of the support substrate 12 with the organic EL part may be detected, the position of the support substrate 12 with the organic EL part is adjusted based on the positional information of the end in the width direction of the support substrate 12 with the organic EL part, and thereafter, the positional information of the alignment mark provided on the support substrate 12 with the organic EL part may be detected. Similarly, the positional information of the end in the width direction of the sealing body 20 may be detected, the position of the sealing body 20 is adjusted based on the positional information of the end in the width direction of the sealing body 20, and thereafter, the positional information of the alignment mark provided on the sealing body 20 may be detected.

In the above embodiments, the mode has been described as an example in which the dehydration treatment for the sealing body 20 is performed between the peeling step S07 and the separation step S08 in the method for manufacturing the organic EL element 1 according to the first embodiment. However, the dehydration treatment for the sealing body 20 may be performed at another timing. For example, the dehydration treatment for the sealing body 20 may be performed before the cutting step. That is, the cuts may be made in the sealing body 20 that has been subjected to the dehydration treatment. When the dehydration treatment for the sealing body 20 is performed before the cutting step, it is preferable to perform the cutting step in a low humidity environment in order to prevent the sealing body 20 from re-absorbing or re-adsorbing moisture.

As in the second embodiment and the third embodiment, when the cutting step, the peeling step, the separation step, and the bonding step are continuously performed with one apparatus, the dehydration treatment is performed, for example, before the peeling step. In this case, there is a need to apply tension to the sealing body 20 during dehydration (during heating), thus causing deformation of the sealing body 20 or making it necessary to provide a mechanism for applying tension different from those in other steps to the sealing body 20. Further, it is necessary to provide a mechanism for controlling air pressure in the apparatus in each step so as to prevent moisture generated in the dehydration treatment from flowing into another step. For this reason, the configuration of the apparatus is likely to be complicated. When the dehydration treatment is performed before the cutting step, the above problem does not occur. Therefore, in the method of performing each step continuously in one apparatus as in the second embodiment and the third embodiment, it is particularly effective to perform the dehydration treatment before the cutting step.

In the above embodiments, the mode has been described as an example in which the separation step S08 is performed after the peeling step S07 in the method for manufacturing the organic EL element 1. However, the peeling step may be performed after the separation step. That is, after separating the sealing member 11 from the sealing body 20, the separate film 19 of the sealing member 11 may be peeled off. Further, the peeling step S07 and the separation step S08 may be performed simultaneously.

In the above embodiments, the mode in which the separate film 19 is provided on the sealing body 20 has been described as an example. However, the sealing body may not be provided with the separate film.

In the above embodiments, the mode in which a cut is made with the cutting blade B from the protective part 17 side in the cutting step has been described as an example. However, the cut may be made with the cutting blade B from the side of the adhesive part 13 (in the case of having the separate film 19, the separate film 19).

In the above embodiments, the mode in which the protective part 17 is provided on the sealing member 11 and the sealing body 20 has been described as an example. However, the sealing member 11 and the sealing body 20 need not be provided with the protective part 17.

In the above embodiments, the mode in which a cut is made in the sealing body 20 with the cutting blade B has been described as an example. However, as the method of making a cut in the sealing body 20, for example, a laser beam (carbon dioxide laser, yttrium-aluminum-garnet (YAG) laser, etc.) can be used.

In addition to the above embodiments, a roller for conveying the sealing member 11 may be further provided between the conveying roller R6 and the rollers R8, R9. Preferably, one to three rollers are provided. In this configuration, the roller R7 that separates the unnecessary portion from the sealing body 20 is preferably disposed immediately before the roller R8 and the roller R9. In this case, the sealing member 11 is bonded immediately after the separation of the sealing member 11 from the sealing body 20 conveyed in the integrally held state, so that a shift in the position of the sealing member 11 can be prevented.

In the above embodiments, the organic EL element has been described as an example of the electronic device. The electronic device may be an organic electronic device such as an organic thin-film transistor, an organic photodetector, or an organic thin-film solar cell, or may be an electronic device using an inorganic material such as a liquid crystal display. In the above embodiments, the organic functional layer containing an organic material has been described as an example of the functional layer, but the functional layer may contain no organic material.

### DESCRIPTION OF REFERENCE SIGNS

1...Organic EL element (Electronic device)
3...Support substrate
3a...One main surface
5...Anode layer (First electrode layer)
7...Organic functional layer (functional layer)
9...Cathode layer (second electrode layer)
10...Organic EL Part (Electronic device part)
11...Sealing member
19...Separate film (Peeling film)
20...Sealing body
S02...Anode layer formation step (Formation step)
S03...Organic functional layer formation step (Formation step)
S04...Cathode layer formation step (Formation step)
S05...Cutting step
S06...Storage step
S07...Peeling step
S08...Separation step
S09...Bonding step

## Claims

1. A method for manufacturing an electronic device, comprising:
a formation step of forming a plurality of electronic device parts, obtained by laminating at least a first electrode layer, a functional layer, and a second electrode layer in this order, on one main surface of a support substrate extending in one direction at predetermined intervals in the one direction;
a bonding step of bonding a band-shaped sealing member, extending in the one direction, along the one direction such that a portion of each of the first electrode layer and the second electrode layer in each of the electronic device parts is exposed and that the sealing member straddles the plurality of electronic device parts;
a cutting step of making a cut in a sealing body that is a parent material of the sealing member and has a larger dimension in a width direction, orthogonal to the one direction, than the sealing member so as to form a width being a width of the sealing member, before the bonding step; and
a separation step of separating the sealing member from the sealing body with the cut made,
wherein in the bonding step, the sealing member, separated from the sealing body in the separation step, is bonded.

2. The method for manufacturing an electronic device according to claim 1, wherein
the sealing body is provided with a peeling film, and
the method comprises a peeling step of peeling off the peeling film from the sealing body after the cutting step and before the bonding step.

3. The method for manufacturing an electronic device according to claim 2, wherein in the cutting step, the cut is made so that the peeling film is not divided in the thickness direction of the peeling film from one surface side of the sealing body located opposite to the other surface of the sealing body where the peeling film is bonded.

4. The method for manufacturing an electronic device according to claim 2 or 3, wherein the separation step is performed after the peeling step.

5. The method for manufacturing an electronic device according to any one of claims 1 to 4, comprising
a storage step of storing the sealing body after the cutting step and before the separation step,
wherein in the separation step, the sealing member is separated from the sealing body stored in the storage step.

6. The method for manufacturing an electronic device according to any one of claims 1 to 5, comprising
a dehydration step of performing a dehydration treatment on the sealing body before the cutting step.

7. The method for manufacturing an electronic device according to any one of claims 1 to 5, comprising
a dehydration step of performing a dehydration treatment on the sealing body after the cutting step and before the separation step.
